# EUROPÄISCHE PATENTSCHRIFT

(11) **EP 4 492 453 B1**
(45) Veröffentlichungstag und Bekanntmachung des Hinweises auf die Patenterteilung: **24.09.2025**
(21) Anmeldenummer: 23184489.5
(22) Anmeldetag: 10.07.2023
(51) Int. Cl.: H01L 23/40

(54) **ELEKTRONISCHE BAUGRUPPE MIT VERBESSERTER MONTAGE EINES KÜHLKÖRPERS**
ELECTRONIC ASSEMBLY WITH IMPROVED MOUNTING OF A HEAT SINK
ENSEMBLE ÉLECTRONIQUE AVEC MONTAGE AMÉLIORÉ D'UN DISSIPATEUR THERMIQUE

(43) Veröffentlichungstag der Anmeldung: 15.01.2025
(73) Patentinhaber: Siemens Aktiengesellschaft, 80333 München (DE)
(72) Erfinder: Sturm, Peter, 91093 Heßdorf (DE)
(74) Vertreter: Siemens Patent Attorneys

(56) Entgegenhaltungen:
- EP-A2- 2 202 790
- WO-A1-2013/078260
- US-A1- 2004 001 315
- US-A1- 2018 321 715

## Beschreibung

Die vorliegende Erfindung geht aus von einer elektronischen Baugruppe,
- wobei die Baugruppe eine Leiterplatte mit einer Bestückungsseite aufweist,
- wobei auf der Bestückungsseite ein elektronisches Bauteil angeordnet ist, das auf seiner von der Leiterplatte abgewandten Seite eine parallel zur Leiterplatte verlaufende Kühlfläche aufweist,
- wobei die Baugruppe einen Kühlkörper aufweist, der mit einer Kontaktfläche auf die Kühlfläche des elektronischen Bauteils aufgesetzt ist,
- wobei die Baugruppe eine Klammer aufweist, die den Kühlkörper an dessen von dem Bauteil abgewandter Seite übergreift und mit der Leiterplatte verbunden ist.

Derartige Baugruppen sind allgemein bekannt. Beispielsweise sind übliche Hauptplatinen (main boards) von PCs so ausgebildet. Auch andere Baugruppen, beispielsweise Steuerungsbaugruppen, die im industriellen Bereich eingesetzt werden, weisen oftmals einen derartigen Aufbau auf.

Das Aufsetzen des Kühlkörpers und der Klammer und das Verbinden der Klammer erfolgen oftmals manuell. Der Kühlkörper und die Klammer werden also nacheinander von Hand auf den Kühlkörper aufgesetzt. Danach wird die Klammer ebenso manuell mit der Leiterplatte verbunden.

Die Vorgehensweise des Standes der Technik ist vor allem deshalb von Nachteil, weil die Kühlfläche des elektronischen Bauteils oftmals relativ klein ist. Dadurch kann es sehr leicht geschehen, dass die Kontaktfläche des Kühlkörpers unter einem gewissen Winkel relativ zur Kühlfläche des elektronischen Bauteils orientiert wird, die Kontaktfläche des Kühlkörpers also relativ zur Kühlfläche des Bauteils gekippt ist. Dadurch verschlechtert sich der thermische Kontakt von dem elektronischen Bauteil zum Kühlkörper, so dass nur eine schlechte Kühlung des elektronischen Bauteils möglich ist. Das elektronische Bauteil wird dadurch nur unzureichend gekühlt. Die unzureichende Kühlung kann auch durch eine zwischen die Kühlfläche und die Kontaktfläche eingebrachte Wärmeleitpaste nicht hinreichend verbessert werden. Dies hat zur Folge, dass entweder das elektronische Bauteil nur mit verringerter Leistungsfähigkeit betrieben werden kann (beispielsweise bei einem Prozessor nur mit einer reduzierten Taktfrequenz) oder sogar relativ bald Schäden und Ausfälle des elektronischen Bauteils und damit der elektronischen Baugruppe insgesamt auftreten. US2004/001315 offenbart eine elektronische Baugruppe **gemäß** dem Oberbegriff des Anspruchs 1

Die Aufgabe der vorliegenden Erfindung besteht darin, Möglichkeiten zu schaffen, mittels derer auf relativ einfache Art und Weise eine parallele oder zumindest nahezu parallele Ausrichtung der Kontaktfläche des Kühlkörpers relativ zur Kühlfläche des elektronischen Bauteils erreicht werden kann. Die Aufgabe wird durch eine elektronische Baugruppe mit den Merkmalen des Anspruchs 1 gelöst. Vorteilhafte Ausgestaltungen der elektronischen Baugruppe sind Gegenstand der abhängigen Ansprüche 2 bis 10.

Erfindungsgemäß wird eine elektronische Baugruppe der eingangs genannten Art dadurch ausgestaltet,
- dass die Baugruppe eine Hilfsstruktur aufweist, die aus einem elektrisch isolierenden Material besteht und auf die Bestückungsseite aufgesetzt ist,
- dass die Hilfsstruktur eine Klammeraufnahme für die Klammer aufweist, in die die Klammer vor dem Aufsetzen der Hilfsstruktur auf die Bestückungsseite einführbar ist,
- dass die Hilfsstruktur eine Kühlkörperaufnahme aufweist, in die der Kühlkörper vor dem Aufsetzen der Hilfsstruktur auf die Bestückungsseite einführbar ist und in der der Kühlkörper gehalten und geführt ist,
- dass die Kühlkörperaufnahme Rückhaltehaken aufweist, mittels derer eine Bewegung des Kühlkörpers in Richtung auf die Leiterplatte zu begrenzt wird, und
- dass nach dem Verbinden der Klammer mit der Leiterplatte entweder der Kühlkörper von den Rückhaltehaken beabstandet ist oder der Kühlkörper mittels der Klammer an die Rückhaltehaken angedrückt wird und die Hilfsstruktur durch dieses Andrücken verbogen wird.

Die elektronische Baugruppe kann insbesondere eine Steuerungsbaugruppe (control unit) einer industriellen Steuerung sein, beispielsweise einer speicherprogrammierbaren Steuerung oder einer numerischen Steuerung oder einer Bewegungssteuerung (motion control).

Die Baugruppe kann mehrere elektronische Bauteile aufweisen, die mittels eines jeweiligen Kühlkörpers gekühlt werden. Entscheidend ist, dass mindestens ein derartiges Bauteil vorhanden ist. Das elektronische Bauteil kann beispielsweise ein Prozessor sein.

Der Kühlkörper weist, wie allgemein üblich, an seiner von der Kontaktfläche abgewandten Seite Kühlrippen auf. Zwischen dem elektronischen Bauteil und den Kühlkörper kann sich eine wärmeleitende Komponente befinden, die zuvor auf die Kühlfläche oder die Kontaktfläche aufgebracht wurde. Die wärmeleitende Komponente kann beispielsweise eine Wärmeleitpaste oder eine Mehrzahl von kleinen wärmeleitenden Polstern (PADs) sein. Die wärmeleitende Komponente kann auch Phasenumwandlungsmaterialien (PCM = phase change material) umfassen.

Das elektronische Bauteil ist in der Regel auf die Leiterplatte aufgelötet. Es ist aber auch möglich, dass das elektronische Bauteil in einen Sockel eingesteckt ist, der seinerseits auf die Leiterplatte aufgelötet ist.

Die Verbindung der Klammer mit der Leiterplatte kann insbesondere mittels Befestigungsschrauben erfolgen.

Das Material, aus dem die Hilfsstruktur besteht, ist in der Regel ein Kunststoff. Es kann sich insbesondere um ein Thermoplast handeln.

Die Ausgestaltung der Klammeraufnahme kann nach Bedarf sein. Insbesondere ist es möglich, dass die Klammeraufnahme Abschnitte der Klammer, die im auf die Bestückungsseite aufgesetzten Zustand der Hilfsstruktur im wesentlichen orthogonal zur Bestückungsseite orientiert sind, an ihren einander zugewandten und/oder an ihren voneinander abgewandten Seiten kontaktiert.

Wenn der Kühlkörper in die Kühlkörperaufnahme eingesetzt ist, ist im wesentlichen nur noch eine gerade, lineare Bewegung des Kühlkörpers möglich. Dies gilt auch dann, wenn die Hilfsstruktur noch nicht auf die Bestückungsseite aufgesetzt ist. Die Bewegungsrichtung entspricht der Richtung, die im auf die Bestückungsseite aufgesetzten Zustand der Hilfsstruktur auf die Leiterplatte zu gerichtet ist.

Eine Bewegung des Kühlkörpers in derjenigen Richtung, die im auf die Bestückungsseite aufgesetzten Zustand der Hilfsstruktur von der Leiterplatte weg gerichtet ist, ist nur in geringem Umfang möglich. Diese Bewegung, also eine Bewegung von den Rückhaltehaken weg, wird entweder durch die Klammer oder durch Elemente der Hilfsstruktur begrenzt.

In vielen Fällen erfolgt beim Aufsetzen der Hilfsstruktur auf die Bestückungsseite zuerst ein Kontakt der Kontaktfläche des Kühlkörpers mit der Kühlfläche des elektronischen Bauteils. In diesem Fall wird der Kühlkörper beim Aufsetzen der Hilfsstruktur auf die Bestückungsseite von den Rückhaltehaken abgehoben. Dadurch ist der Kühlkörper ab diesem Zeitpunkt und damit auch nach dem Verbinden der Klammer mit der Leiterplatte von den Rückhaltehaken beabstandet. Ein derartiger Abstand des Kühlkörpers von den Rückhaltehaken ist oftmals sehr gering, meist maximal 2 mm. Alternativ ist es möglich, dass die Hilfsstruktur so schwach ausgelegt ist, dass beim Verbinden der Klammer mit der Leiterplatte zwar der Kühlkörper wieder auf die Rückhaltehaken abgesenkt wird, in Verbindung mit dem damit einhergehenden Andrücken des Kühlkörpers an die Rückhaltehaken jedoch die Hilfsstruktur verbogen wird.

Vorzugsweise ist die Klammeraufnahme derart ausgebildet, dass die Klammer von derjenigen Seite der Hilfsstruktur aus, die im auf die Bestückungsseite aufgesetzten Zustand der Hilfsstruktur der Leiterplatte zugewandt ist, (und nur von dieser Seite aus) in die Klammeraufnahme einführbar ist. Dies vereinfacht die Konstruktion der Hilfsstruktur.

Vorzugsweise ist die Klammer, wenn sie sich in der Klammeraufnahme befindet, auch vor dem Einführen des Kühlkörpers in die Kühlkörperaufnahme und vor dem Aufsetzen der Hilfsstruktur auf die Bestückungsseite in der Hilfsstruktur unverlierbar gehalten. Dies führt insbesondere zu einer verbesserten Zuverlässigkeit im Rahmen des Herstellungsvorgangs der elektronischen Baugruppe. Denn wenn beispielsweise die Hilfsstruktur nach dem Einführen der Klammer in die Klammeraufnahme von einer Montagestation A zu einer Montagestation B transportiert wird, in der beispielsweise die Kühlkörper in die Kühlkörperaufnahme eingesetzt wird, kann die Klammer während dieses Transports nicht verloren gehen.

Vorzugsweise ist die Kühlkörperaufnahme derart ausgebildet, dass der Kühlkörper von derjenigen Seite der Hilfsstruktur aus, die im auf die Bestückungsseite aufgesetzten Zustand der Hilfsstruktur der Leiterplatte zugewandt ist, (und nur von dieser Seite aus) in die Kühlkörper einführbar ist. Dies vereinfacht die Konstruktion der Hilfsstruktur.

Vorzugsweise weist die Hilfsstruktur Abstandhalter auf, die von der Bestückungsseite der Leiterplatte weg ragen und in dieser Richtung den Kühlkörper überragen.

Der Vorteil dieser Ausgestaltung ist die einfache Handhabung der Hilfsstruktur beim Einführen der Klammer in die Klammeraufnahme und des Kühlkörpers in die Kühlkörperaufnahme vor dem Aufsetzen der Hilfsstruktur auf die Bestückungsseite. Denn es ist möglich, die Hilfsstruktur auf eine flache Unterlage (beispielsweise der Oberfläche eines Tisches) aufzulegen, so dass die Hilfsstruktur mit den Abstandhaltern auf der Unterlage aufsteht (also sozusagen "verkehrt herum"). Sodann können - bei dieser Positionierung und Orientierung der Hilfsstruktur - nacheinander die Klammer und der Kühlkörper von oben in die Hilfsstruktur eingeführt werden. Nach dem Einführen der Klammer und des Kühlkörpers in die Hilfsstruktur sind die Klammer und der Kühlkörper in der Hilfsstruktur vorfixiert, so dass die Hilfsstruktur zusammen mit der Klammer und dem Kühlkörper auf die Bestückungsseite der Leiterplatte aufgesetzt werden kann.

Vorzugsweise weist die Hilfsstruktur Anschläge auf, mittels derer eine Bewegung des Kühlkörpers in Richtung von der Leiterplatte weg begrenzt wird. Dadurch kann insbesondere unabhängig von der exakten Positionierung der Klammer in der Hilfsstruktur und unabhängig von der Auslegung der Klammer eine Vorfixierung des Kühlkörpers innerhalb der Hilfsstruktur gewährleistet werden.

Die Positionierung der Rückhaltehaken und der Anschläge kann insbesondere derart auf den Kühlkörper abgestimmt sein, dass der Kühlkörper in der Kühlkörperaufnahme um maximal 5 mm bewegbar ist. Allgemein gilt hierbei, dass die Zuverlässigkeit, mit welcher die Kontaktfläche des Kühlkörpers parallel (oder nahezu parallel) zur Kühlfläche des elektronischen Bauteils ausgerichtet wird, umso größer ist, je geringer die Bewegbarkeit des Kühlkörpers in der Kühlkörperaufnahme ist. Andererseits muss in der Regel ein gewisses Minimum an Bewegbarkeit möglich sein, um Toleranzen ausgleichen zu können. In vielen Fällen reicht es aus, wenn der Kühlkörper in der Kühlkörperaufnahme um weniger als 5 mm bewegbar ist, beispielsweise um maximal 4 mm, maximal 3 mm oder maximal 2 mm. Werte unterhalb von 2 mm sind zwar in manchen Fällen möglich, meist jedoch nicht erforderlich.

Vorzugsweise wird der in der Kühlkörperaufnahme angeordnete Kühlkörper bei in die Klammeraufnahme eingesetzter Klammer vor dem Aufsetzen der Hilfsstruktur auf die Bestückungsseite von der Klammer an die Rückhaltehaken angedrückt. Dadurch ergeben sich vor dem Aufsetzen der Hilfsstruktur auf die Bestückungsseite definierte Positionierungen der Klammer und des Kühlkörpers in der Hilfsstruktur.

Vorzugsweise weist die Hilfsstruktur Positionierstifte auf, die in Ausnehmungen der Leiterplatte eingeführt sind. Das Einführen der Positionierstifte in die Ausnehmungen erfolgt beim Aufsetzen der Hilfsstruktur auf die Bestückungsseite. Durch die Positionierstifte wird die exakte Positionierung der Hilfsstruktur erleichtert.

Vorzugsweise ist die Hilfsstruktur mit der Leiterplatte über die Außenseite der Leiterplatte übergreifende Rasthaken verrastet. Diese Art der Verbindung ist besonders einfach zu realisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: Teile einer elektronischen Baugruppe von der Seite,
- FIG 2: die Teile der elektronischen Baugruppe von FIG 1 von oben,
- FIG 3: einen Kühlkörper und eine Klammer von unten,
- FIG 4: eine elektronische Baugruppe beim Aufsetzen einer Hilfsstruktur auf eine Bestückungsseite einer Leiterplatte,
- FIG 5: eine Hilfsstruktur in perspektivischer Darstellung,
- FIG 6: die Hilfsstruktur von FIG 5 mit eingesetzten Klammern,
- FIG 7: die Hilfsstruktur von FIG 5 mit eingesetzten Klammern und eingesetzten Kühlkörpern,
- FIG 8: eine Klammer von vorne,
- FIG 9: die Klammer von FIG 8 von oben,
- FIG 10: die Klammer von FIG 8 von der Seite,
- FIG 11: jeweils teilweise einen Kühlkörper, eine Klammer und eine Hilfsstruktur,
- FIG 12: jeweils teilweise einen Kühlkörper, eine Klammer und eine Hilfsstruktur,
- FIG 13: eine elektronische Baugruppe und
- FIG 14: jeweils teilweise einen Kühlkörper, eine Klammer und eine Hilfsstruktur.

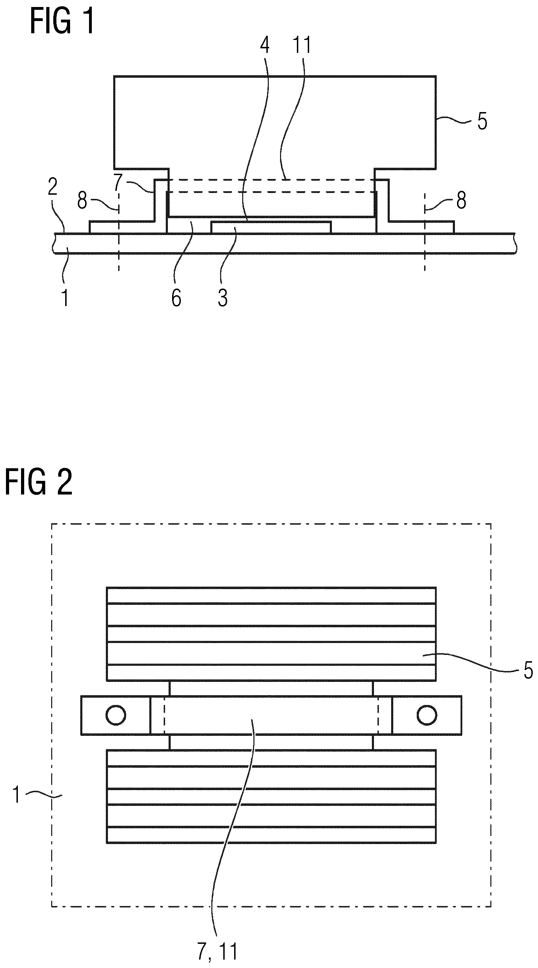

Gemäß den FIG 1 und 2 weist eine elektronische Baugruppe eine Leiterplatte 1 auf. Die Leiterplatte 1 weist eine Bestückungsseite 2 auf. Auf der Bestückungsseite 2 ist ein elektronisches Bauteil 3 angeordnet.

In der Regel ist auf der Bestückungsseite 2 eine Vielzahl von elektronischen Bauteilen 3 angeordnet. Vorliegend wird jedoch nur das einzelne, mit dem Bezugszeichen 3 bezeichnete Bauteil näher betrachtet.

Bei dem elektronischen Bauteil 3 kann es sich beispielsweise um einen Prozessor handeln. Unabhängig davon, von welcher Art das Bauteil 3 ist, weist das elektronische Bauteil 3 auf seiner von der Leiterplatte 1 abgewandten Seite eine Kühlfläche 4 auf. Die Kühlfläche 4 verläuft parallel zur Leiterplatte 1, genauer gesagt parallel zur Bestückungsseite 2.

Ein Kühlkörper 5 der Baugruppe ist mit einer Kontaktfläche 6 auf die Kühlfläche 4 des elektronischen Bauteils 3 aufgesetzt. Der in FIG 1 dargestellte Abstand der Kontaktfläche 6 zur Kühlfläche 4 ist in der Realität nicht vorhanden. Zwischen der Kühlfläche 4 und der Kontaktfläche 6 kann (nicht dargestellt) eine wärmeleitende Komponente angeordnet sein.

Eine Klammer 7 übergreift den Kühlkörper 5 an derjenigen Seite, die von dem Bauteil 3 (und auch der Leiterplatte 1) und abgewandt ist. Die Klammer 7 ist mit der Leiterplatte 1 verbunden, beispielsweise über schematisch angedeutete Verbindungsschrauben 8. Die Kühlrippen des Kühlkörpers 5 sind in FIG 2 dargestellt, aber nicht mit einem Bezugszeichen versehen.

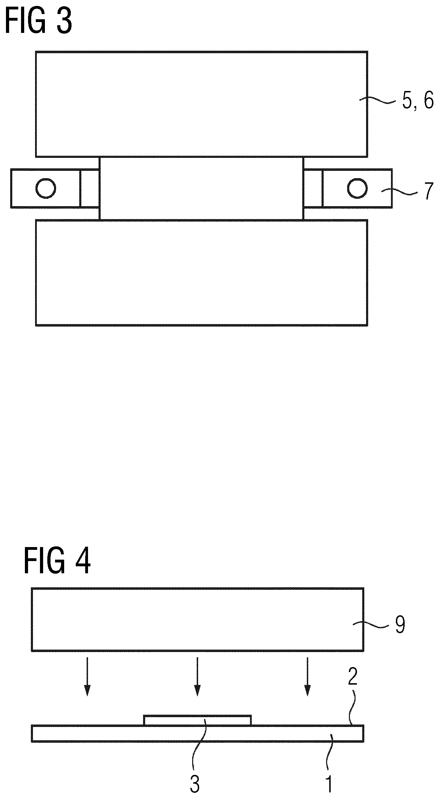

FIG 3 zeigt beispielhaft eine mögliche Ausgestaltung des Kühlkörpers 5 und das zugehörige Zusammenwirken mit der Klammer 7 von der Unterseite aus gesehen, also von der Leiterplatte 1 aus gesehen.

Zum Befestigen des Kühlkörpers 5 und der Klammer 7 weist die elektronische Baugruppe gemäß FIG 4 eine Hilfsstruktur 9 auf. Die Hilfsstruktur 9 besteht aus einem elektrisch isolierenden Material. Sie wird, wie in FIG 4 durch Pfeile angedeutet, auf die Bestückungsseite 2 aufgesetzt. Vor dem Aufsetzen auf die Bestückungsseite 2 werden der Kühlkörper 5 und die Klammer 7 in der Hilfsstruktur 9 angeordnet. Nach dem Aufsetzen der Hilfsstruktur 9 auf die Bestückungsseite 2 wird die Klammer 7 mit der Leiterplatte 1 verbunden und dadurch die Kontaktfläche 6 des Kühlkörpers 5 mittels der Klammer 7 an die Kühlfläche 4 des elektronischen Bauteils 3 angedrückt.

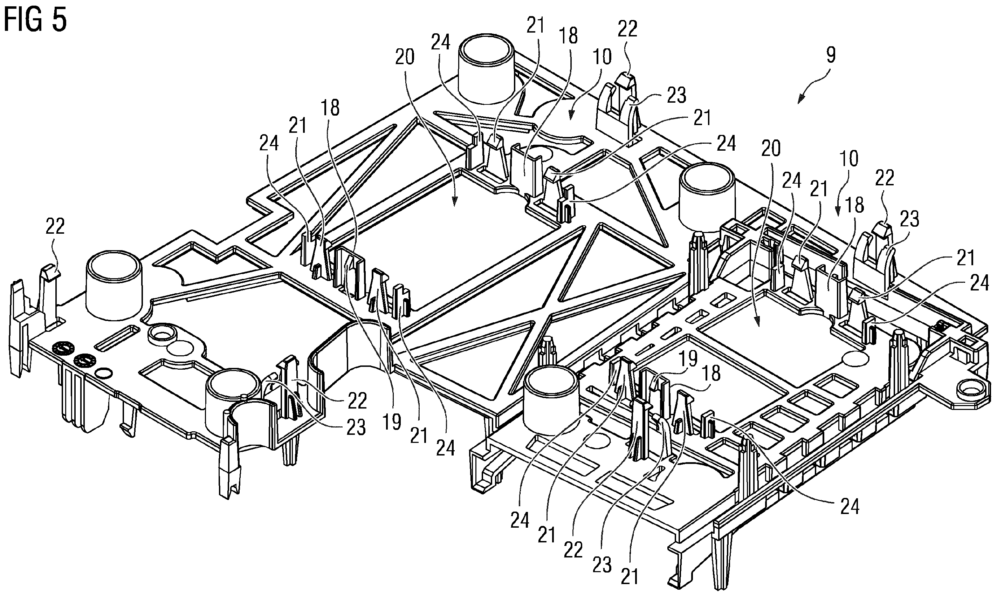

Nachfolgend wird zunächst in Verbindung mit den FIG 5 bis 7 der strukturelle Aufbau der Hilfsstruktur 9 erläutert. In Verbindung mit den FIG 5 bis 7 wird auch das Bestücken der Hilfsstruktur 9 mit dem Kühlkörper 5 und der Klammer 7 erläutert.

Aus den späteren Erläuterungen zu den FIG 5 bis 7 wird hervorgehen, dass die Hilfsstruktur 9 für die Aufnahme von zwei Kühlkörpern 5 und zwei zugehörigen Klammern 7 ausgelegt ist. In Verbindung mit dieser konkreten Ausgestaltung wird die Hilfsstruktur 9 nachstehend erläutert. Es ist jedoch auch ausreichend, wenn die Hilfsstruktur 9 nur für die Aufnahme eines einzigen Kühlkörpers 5 und einer einzigen Klammer 7 ausgelegt ist. Ebenso könnte die Hilfsstruktur 9 auch für die Aufnahme von mehr als zwei Kühlkörpern 5 und hiermit korrespondierend mehr als zwei zugehörigen Klammern 7 ausgelegt sein.

Gemäß den FIG 5 bis 7 weist die Hilfsstruktur 9 für die Klammern 7 jeweils eine Klammeraufnahme 10 auf. Die Klammeraufnahmen 10 sind auf die Klammern 7 abgestimmt. Die Klammeraufnahme 10 für die jeweilige Klammer 7 ist derart auf die Klammer 7 abgestimmt, dass die jeweilige Klammer 7 vor dem Aufsetzen der Hilfsstruktur 9 auf die Bestückungsseite 2 der Leiterplatte 1 in die jeweilige Klammeraufnahme 10 einführbar ist.

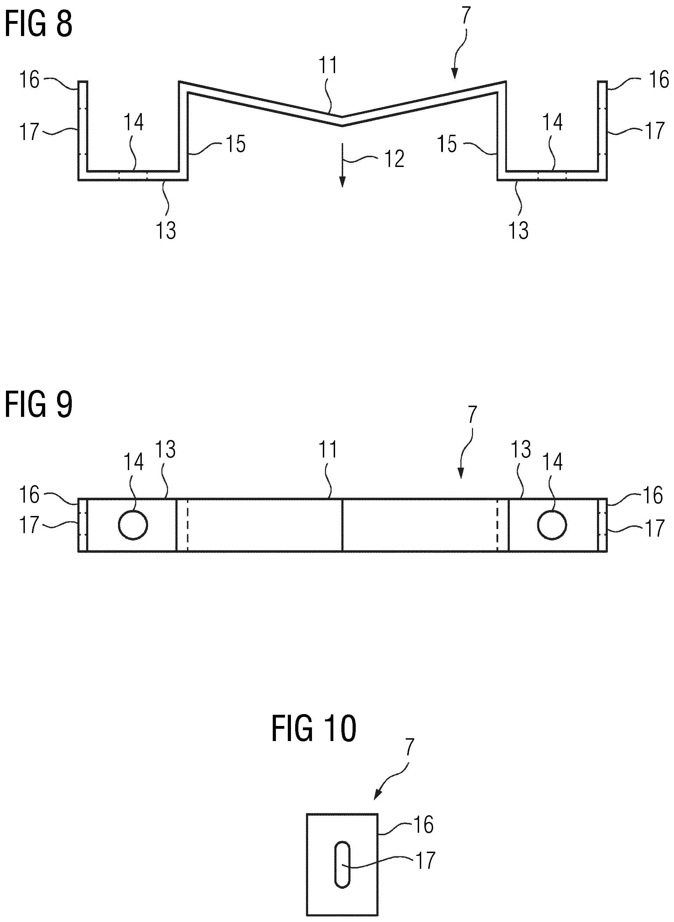

Für die spezifische Ausgestaltung der Klammern 7 und der Klammeraufnahmen 10 gibt es mehrere Möglichkeiten. Vorliegend sind die Klammern 7 gemäß den FIG 8 bis 10 beispielsweise derart ausgebildet, dass sie in einem mittleren Bereich eine Druckfläche 11 aufweisen. Die Druckfläche 11 ist gemäß den FIG 1 und 2 im montierten Zustand (wenn also die Klammer 7 mit der Leiterplatte 1 verbunden ist) an die Oberseite des Kühlkörpers 5 angedrückt. Die Druckfläche 11 kann insbesondere gewölbt oder gewinkelt sein, so dass bei einem Absenken der Klammer 7 in einer in FIG 8 mit 12 bezeichneten Richtung zunächst der mittlere Bereich der Druckfläche 11 den Kühlkörper 5 berührt und danach die Klammer 7 unter Aufbau einer Druckkraft gebogen wird.

An die Druckfläche 11 schließen sich beidseits Befestigungsbereiche 13 an, mit denen die jeweilige Klammer 7 mit der Leiterplatte 1 verbunden ist. Beispielsweise können die Befestigungsbereiche 13 Ausnehmungen 14 für den Durchtritt der Verbindungsschrauben 8 aufweisen. Die Befestigungsbereiche 13 sind mit der Druckfläche 11 über Übergangsabschnitte 15 verbunden. Die Übergangsabschnitte 15 sind im montierten Zustand der jeweiligen Klammer 7 im wesentlichen orthogonal zur Leiterplatte 1 orientiert, während die Druckfläche 11 und die Befestigungsbereiche 13 im wesentlichen parallel zur Leiterplatte 1 verlaufen. An die Befestigungsbereiche 13 schließen sich außen Abschlussbereiche 16 an. Die Abschlussbereiche 16 sind im montierten Zustand der jeweiligen Klammer 7 ebenfalls im wesentlichen orthogonal zur Leiterplatte 1 orientiert. Die Abschlussbereiche 16 können beispielsweise jeweils ein Langloch 17 aufweisen. In diesem Fall kann die jeweilige Klammer 7 mittels der beiden Langlöcher 17 an ihren Enden an der Hilfsstruktur 9 montiert sein.

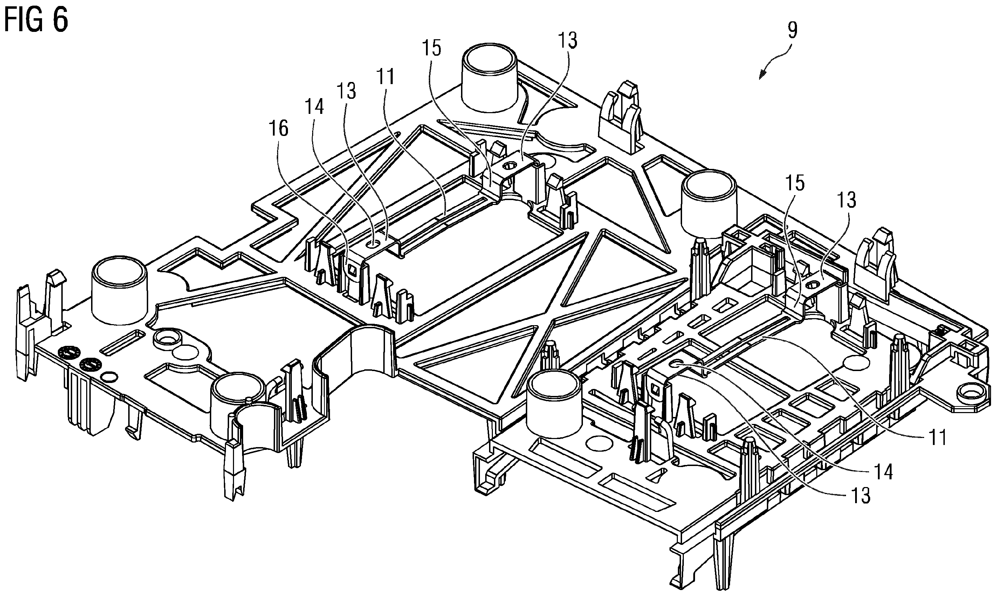

Im Falle dieser konkreten Ausgestaltung der Klammern 7 kann die Hilfsstruktur 9 als Klammeraufnahme 10 beispielsweise Stege 18 aufweisen, deren Flächen beim Einsetzen der Klammer 7 in die Klammeraufnahme 10 an den einander zugewandten Seiten (alternativ: an den voneinander abgewandten Seiten) der Abschlussbereiche 16 zu liegen kommen. In diesem Fall können die Stege 18 beispielsweise leicht federnd ausgebildet sein und an den entsprechenden Flächen beispielsweise einen Vorsprung 19 aufweisen, der beim Einsetzen der jeweiligen Klammer 7 in die jeweilige Klammeraufnahme 10 in die entsprechenden Langlöcher 17 eingeführt wird. FIG 6 zeigt den entsprechenden Zustand der Hilfsstruktur 9.

Die Klammern 7 weisen gemäß der Darstellung in FIG 6 im Bereich der jeweiligen Druckfläche 11 jeweils eine Längsausnehmung auf. Diese Ausgestaltung der Klammern 7 ist bevorzugt, im Rahmen der vorliegenden Erfindung jedoch von untergeordneter Bedeutung.

Diejenige Seite der Hilfsstruktur 9, die später (nach dem Aufsetzen der Hilfsstruktur 9 auf die Bestückungsseite 2) der Bestückungsseite 2 zugewandt ist, ist in der Darstellung der FIG 5 bis 7 oben angeordnet. Auch das Einführen der jeweiligen Klammer 7 in die jeweilige Klammeraufnahme 10 erfolgt (in der Darstellung der FIG 5 bis 7) von oben. Somit wird die jeweilige Klammer 7 von derjenigen Seite der Hilfsstruktur 9 aus, die im auf die Bestückungsseite 2 aufgesetzten Zustand der Hilfsstruktur 9 der Leiterplatte 1 zugewandt ist, in die Klammeraufnahme 10 eingesetzt. Diese Ausgestaltung ist bevorzugt.

Aufgrund der Vorsprünge 19 ist weiterhin die jeweilige Klammer 7, wenn sie sich in der jeweiligen Klammeraufnahme 10 befindet, in der Hilfsstruktur 9 unverlierbar gehalten. Dies gilt ab dem Einführen der jeweiligen Klammer 7 in die jeweilige Klammeraufnahme 10 und damit insbesondere auch vor dem Einführen des jeweiligen Kühlkörpers 5 in eine jeweilige Kühlkörperaufnahme 20 (wird nachstehend erläutert) und auch vor dem Aufsetzen der Hilfsstruktur 9 auf die Bestückungsseite 2.

Gemäß den FIG 5 bis 7 weist die Hilfsstruktur 9 weiterhin für die Kühlkörper 5 jeweils die bereits erwähnte Kühlkörperaufnahme 20 auf. Die Kühlkörperaufnahmen 20 sind auf die Kühlkörper 5 abgestimmt. Die Kühlkörperaufnahme 20 für den jeweiligen Kühlkörper 5 ist derart auf den jeweiligen Kühlkörper 5 abgestimmt, dass der jeweilige Kühlkörper 5 vor dem Aufsetzen der Hilfsstruktur 9 auf die Bestückungsseite 2 in die jeweilige Kühlkörperaufnahme 20 einführbar ist und der Kühlkörper 5 in der jeweiligen Kühlkörperaufnahme 20 gehalten und geführt ist.

Die Kühlkörperaufnahmen 20 weisen - beispielsweise in den Eckbereichen - Rückhaltehaken 21 auf. Mittels der Rückhaltehaken 21 wird eine Bewegung des jeweiligen Kühlkörpers 5 in Richtung auf die Leiterplatte 1 zu begrenzt.

Somit erfolgt auch das Einführen des jeweiligen Kühlkörpers 5 in die jeweilige Kühlkörperaufnahme 20 in der Darstellung der FIG 5 bis 7 von oben. Somit wird der jeweilige Kühlkörper 5 von derjenigen Seite der Hilfsstruktur 9 aus, die im auf die Bestückungsseite 2 aufgesetzten Zustand der Hilfsstruktur 9 der Leiterplatte 1 zugewandt ist, in die jeweilige Kühlkörperaufnahme 20 eingesetzt. Diese Ausgestaltung bedingt unter anderem, dass der jeweilige Kühlkörper 5 erst nach dem Einführen der zugehörigen Klammer 7 in die entsprechende Klammeraufnahme 10 in seine Kühlkörperaufnahme 20 eingeführt wird.

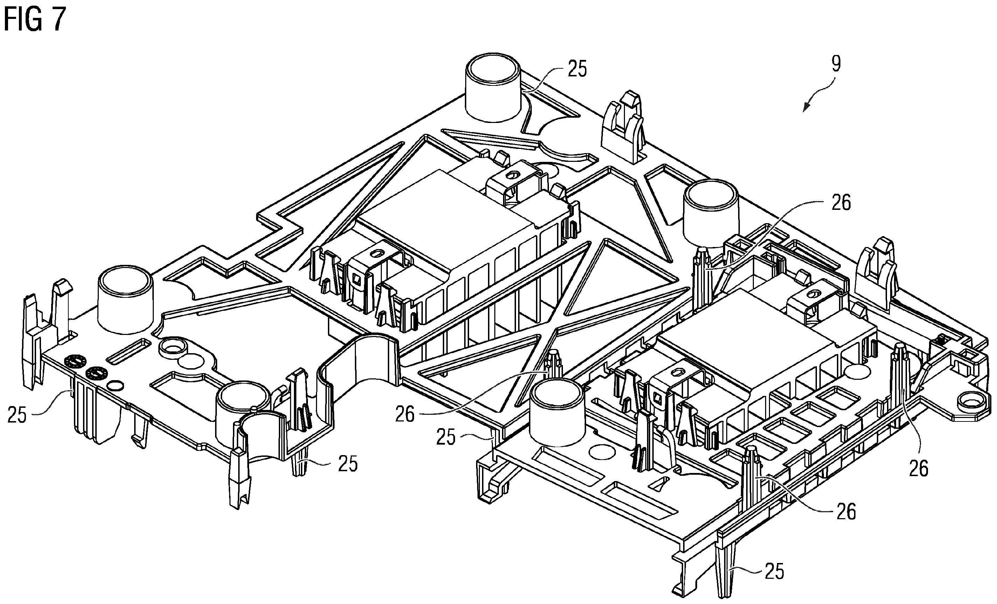

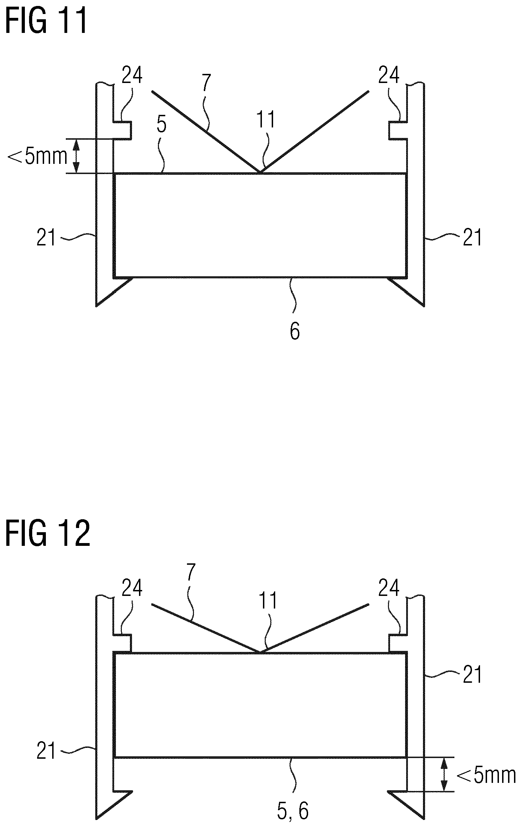

Die vorstehend erläuterte Ausgestaltung ist bevorzugt. FIG 7 zeigt den entsprechenden Zustand der Hilfsstruktur 9. In diesem Zustand (also insbesondere noch vor dem Aufsetzen der Hilfsstruktur 9 auf die Bestückungsseite 2) wird der jeweilige Kühlkörper 5 von der jeweiligen Klammer 7 an die Rückhaltehaken 21 angedrückt. Hierbei ist, wie bereits erwähnt, der jeweilige Kühlkörper 5 in die jeweilige Kühlkörperaufnahme 20 eingesetzt und ist auch die jeweilige Klammer 7 in die jeweilige Klammeraufnahme 10 eingesetzt. FIG 11 zeigt deutlich vereinfacht diesen Zustand.

Nach dem Einführen der Klammern 7 in die Klammernaufnahmen 10 und dem Einführen der Kühlkörper 5 in die Kühlkörperaufnahmen 20 ist die Hilfsstruktur 9 bestückt. Die Hilfsstruktur 9 kann daher jetzt - vergleiche FIG 4 - auf die Bestückungsseite 2 der Leiterplatte 1 aufgesetzt werden. Beim Aufsetzen ist diejenige Seite der Hilfsstruktur 9, die in den FIG 5 bis 7 oben ist, der Bestückungsseite 2 zugewandt. Zum Befestigen der Hilfsstruktur 9 an der Leiterplatte 1 weist die Hilfsstruktur 9 gemäß den FIG 5 bis 7 vorzugsweise Rasthaken 22 auf. Die Rasthaken 22 übergreifen die Leiterplatte 1 an ihrer Außenseite. Über die Rasthaken 22 ist die Hilfsstruktur 9 im Zusammenwirken mit Widerlagern 23 der Hilfsstruktur 9 mit der Leiterplatte 1 verrastet.

Während des Aufsetzens der Hilfsstruktur 9 auf die Bestückungsseite 2 - also noch bevor das Aufsetzen der Hilfsstruktur 9 auf die Bestückungsseite 2 abgeschlossen ist - kontaktiert vorzugsweise die Kontaktfläche 6 des jeweiligen Kühlkörpers 5 die Kühlfläche 4 des jeweiligen elektronischen Bauteils 3. Wenn das Aufsetzen der Hilfsstruktur 9 auf die Bestückungsseite 2 abgeschlossen ist, ist daher der jeweilige Kühlkörper 5 von den Rückhaltehaken 21 der jeweiligen Kühlkörperaufnahme 20 beabstandet. FIG 12 zeigt den entsprechenden Zustand. Die Kühlrippen der Kühlkörper 5 sind bei der Darstellung von FIG 12 nicht längs orientiert, sondern quer orientiert. Dies ist im Rahmen der vorliegenden Erfindung von untergeordneter Bedeutung.

Vorzugsweise weist die Hilfsstruktur 9 - siehe wieder FIG 11 - Anschläge 24 auf, mittels derer die Bewegung des jeweiligen Kühlkörpers 5 - also das Zurückweichen des jeweiligen Kühlkörpers 5 in der jeweiligen Kühlkörperaufnahme 20 in Richtung von der Leiterplatte 1 weg, begrenzt wird. Die Positionierung der Rückhaltehaken 21 und der Anschläge 24 kann insbesondere derart auf den jeweiligen Kühlkörper 5 abgestimmt sein, dass der jeweilige Kühlkörper 5 in der jeweiligen Kühlkörperaufnahme 20 um maximal 5 mm bewegbar ist.

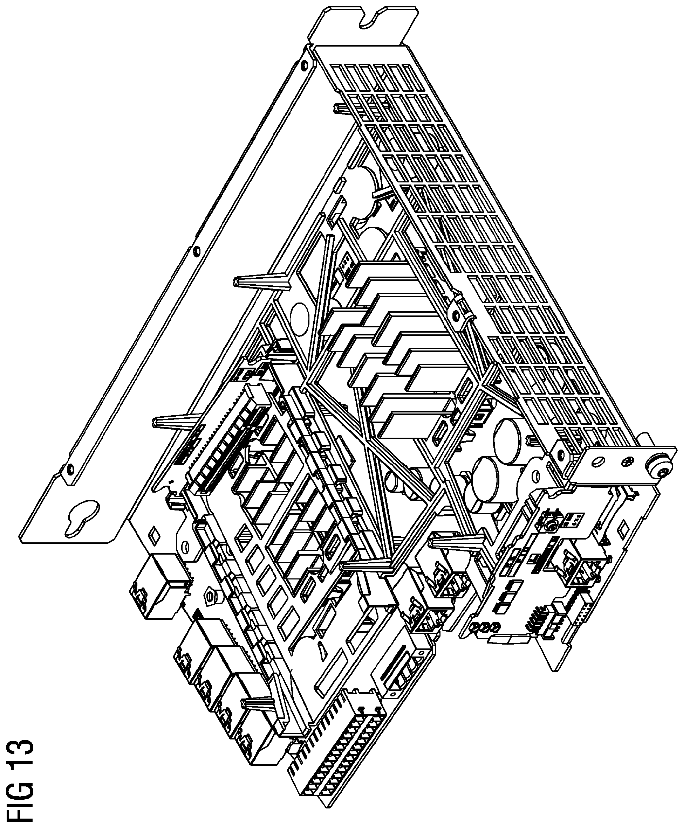

Die Anschläge 24 sind in den FIG 11 und 13 als Bestandteile der Rückhaltehaken 21 dargestellt. Diese Ausgestaltung ist zwar möglich, in der Regel aber nicht bevorzugt. Bevorzugt ist eine Ausgestaltung, bei der entsprechend der Darstellung in den FIG 5 bis 7 die Anschläge 24 eigenständige Elemente sind, die neben den Rückhaltehaken 21 angeordnet sind.

Beim nachfolgenden Verbinden der Klammern 7 mit der Leiterplatte 1 werden die Kühlkörper 5 meist wieder etwas auf die Leiterplatte 1 zu abgesenkt. FIG 13 zeigt die elektronische Baugruppe nach dem Aufsetzen der Hilfsstruktur 9 auf die Bestückungsseite 2.

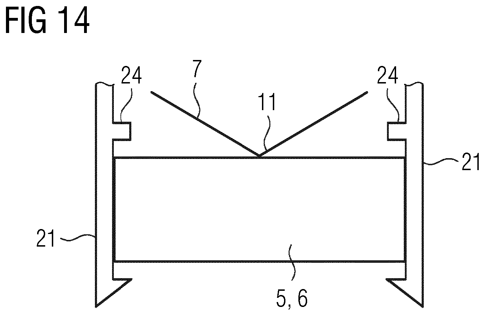

Meist befindet sich der jeweilige Kühlkörper 5 nach dem Verbinden der Klammern 7 mit der Leiterplatte 1 entsprechend der Darstellung in FIG 14 innerhalb der jeweiligen Kühlkörperaufnahme 20 zwischen den beiden in den FIG 11 und 12 dargestellten Extrempositionen. Vorzugsweise ist also auch nach dem Verbinden der jeweiligen Klammer 7 mit der Leiterplatte 1 der jeweilige Kühlkörper 5 von den Rückhaltehaken 21 beabstandet.

Alternativ und in den FIG nicht dargestellt ist es möglich, dass der jeweilige Kühlkörper 5 mittels der jeweiligen Klammer 7 wieder an die Rückhaltehaken 21 angedrückt wird. In diesem Fall dürfen die Rückhaltehaken 21 jedoch das Andrücken des jeweiligen Kühlkörpers 5 an das zugehörige elektronische Bauteil 3 nicht behindern. Die Hilfsstruktur 9 muss daher in diesem Fall so nachgiebig ausgestaltet sein, dass die Hilfsstruktur 9 durch das Andrücken des jeweiligen Kühlkörpers 5 an die Rückhaltehaken 21 verbogen wird, die Hilfsstruktur 9 also nachgibt.

Zum einfachen Bestücken der Hilfsstruktur 9 weist die Hilfsstruktur 9 gemäß den FIG 5 bis 7 vorzugsweise Abstandhalter 25 auf. Die Abstandhalter 25 ragen im montierten Zustand von der Bestückungsseite 2 der Leiterplatte 1 weg. Meist sind die Abstandhalter 25 zumindest im Bereich der Ecken der Hilfsstruktur 9 angeordnet. Weiterhin überragen die Abstandhalter 25 in der genannten Richtung - also von der Bestückungsseite 2 der Leiterplatte 1 weg - den Kühlkörper 5 (bzw. bei mehreren Kühlkörpern 5 die Kühlkörper 5). Dadurch ist es möglich, die Hilfsstruktur 9, wie sie in den FIG 5 bis 7 dargestellt ist, mit den Abstandhaltern 25 auf eine Tischoberfläche oder dergleichen aufzusetzen und sodann problemlos die Bestückung mit den Klammern 7 und den Kühlkörpern 5 vorzunehmen.

Zum leichten Positionieren der Hilfsstruktur 9 beim Aufsetzen auf die Bestückungsseite 2 kann die Hilfsstruktur 9 gemäß den FIG 5 bis 7 weiterhin Positionierstifte 26 aufweisen. Die Positionierstifte 26 sind in diesem Fall in entsprechende Ausnehmungen der Leiterplatte 1 (nicht dargestellt) eingeführt. Dadurch wird gewährleistet, dass die seitliche Positionierung der Hilfsstruktur 9 relativ zur Leiterplatte 1 ordnungsgemäß ist.

Zusammengefasst betrifft die vorliegende Erfindung somit folgenden Sachverhalt:
Eine elektronische Baugruppe weist eine Leiterplatte 1 mit einer Bestückungsseite 2 auf. Auf der Bestückungsseite 2 ist ein elektronisches Bauteil 3 angeordnet, das auf seiner von der Leiterplatte 1 abgewandten Seite eine parallel zur Leiterplatte 1 verlaufende Kühlfläche 4 aufweist. Die Baugruppe weist einen Kühlkörper 5 auf, der mit einer Kontaktfläche 6 auf die Kühlfläche 4 des elektronischen Bauteils 3 aufgesetzt ist. Die Baugruppe weist eine Klammer 7 auf, die den Kühlkörper 5 an dessen von dem Bauteil 3 abgewandten Seite übergreift und mit der Leiterplatte 1 verbunden ist. Die Baugruppe weist eine Hilfsstruktur 9 auf, die aus einem elektrisch isolierenden Material besteht und auf die Bestückungsseite 2 aufgesetzt ist. Die Hilfsstruktur 9 weist eine Klammeraufnahme 10 für die Klammer 7 auf, in die die Klammer 7 vor dem Aufsetzen der Hilfsstruktur 9 auf die Bestückungsseite 2 einführbar ist. Die Hilfsstruktur 9 weist eine Kühlkörperaufnahme 20 auf, in die der Kühlkörper 5 vor dem Aufsetzen der Hilfsstruktur 9 auf die Bestückungsseite 2 einführbar ist und in der der Kühlkörper 5 gehalten und geführt ist. Die Kühlkörperaufnahme 20 weist Rückhaltehaken 21 auf, mittels derer eine Bewegung des Kühlkörpers 5 in Richtung auf die Leiterplatte 1 zu begrenzt wird. Nach dem Verbinden der Klammer 7 mit der Leiterplatte 1 ist entweder der Kühlkörper 5 von den Rückhaltehaken 21 beabstandet oder werden der Kühlkörper 5 mittels der Klammer 7 an die Rückhaltehaken 21 angedrückt und die Hilfsstruktur 9 durch dieses Andrücken verbogen.

Die vorliegende Erfindung weist viele Vorteile auf. Es ergibt sich eine erheblich einfachere und zuverlässigere Montage des Kühlkörpers 5 auf dem elektronischen Bauteil 3. Die Wärmeabfuhr ist zuverlässig. Insbesondere wird durch die Abstände der Rückhaltehaken 21 und der Anschläge 24, welche in der durch die Leiterplatte 1 definierten Ebene betrachtet die Abmessungen der Kühlfläche 4 und der Kontaktfläche 6 deutlich übersteigen, eine erheblich bessere Ausrichtung der Kontaktfläche 6 relativ zur Kühlfläche 4 erreicht. Die Kühlkörperaufnahmen 20 halten die Kühlkörper 5 auch beim Anziehen der Verbindungsschrauben 8 in ihrer Position und verhindern vollständig oder zumindest nahezu vollständig ein Verkippen der Kühlkörper 5. Die Montage kann sogar automatisiert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektronische Baugruppe,
- wobei die Baugruppe eine Leiterplatte (1) mit einer Bestückungsseite (2) aufweist,
- wobei auf der Bestückungsseite (2) ein elektronisches Bauteil (3) angeordnet ist, das auf seiner von der Leiterplatte (1) abgewandten Seite eine parallel zur Leiterplatte (1) verlaufende Kühlfläche (4) aufweist,
- wobei die Baugruppe einen Kühlkörper (5) aufweist, der mit einer Kontaktfläche (6) auf die Kühlfläche (4) des elektronischen Bauteils (3) aufgesetzt ist,
- wobei die Baugruppe eine Klammer (7) aufweist, die den Kühlkörper (5) an dessen von dem Bauteil (3) abgewandter Seite übergreift und mit der Leiterplatte (1) verbunden ist,
- wobei die Baugruppe eine Hilfsstruktur (9) aufweist, die auf die Bestückungsseite (2) aufgesetzt ist,
- wobei die Hilfsstruktur (9) eine Klammeraufnahme (10) für die Klammer (7) aufweist, in die die Klammer (7) vor dem Aufsetzen der Hilfsstruktur (9) auf die Bestückungsseite (2) einführbar ist,
- wobei die Hilfsstruktur (9) eine Kühlkörperaufnahme (20) aufweist, in die der Kühlkörper (5) vor dem Aufsetzen der Hilfsstruktur (9) auf die Bestückungsseite (2) einführbar ist und in der der Kühlkörper (5) gehalten und geführt ist,
- **dadurch gekennzeichnet, dass** die Hilfsstruktur (9) aus einem elektrisch isolierenden Material besteht, dass die Kühlkörperaufnahme (20) Rückhaltehaken (21) aufweist, mittels derer eine Bewegung des Kühlkörpers (5) in Richtung auf die Leiterplatte (1) zu begrenzt wird, und
- dass nach dem Verbinden der Klammer (7) mit der Leiterplatte (1) entweder der Kühlkörper (5) von den Rückhaltehaken (21) beabstandet ist oder der Kühlkörper (5) mittels der Klammer (7) an die Rückhaltehaken (21) angedrückt wird und die Hilfsstruktur (9) durch dieses Andrücken verbogen wird.

2. Elektronische Baugruppe nach Anspruch 1,
**dadurch gekennzeichnet,**
**dass** die Klammeraufnahme (10) derart ausgebildet ist, dass die Klammer (7) von derjenigen Seite der Hilfsstruktur (9) aus, die im auf die Bestückungsseite (2) aufgesetzten Zustand der Hilfsstruktur (9) der Leiterplatte (1) zugewandt ist, in die Klammeraufnahme (10) einführbar ist.

3. Elektronische Baugruppe nach Anspruch 1 oder 2,
**dadurch gekennzeichnet,**
**dass** die Klammer (7), wenn sie sich in der Klammeraufnahme (10) befindet, auch vor dem Einführen des Kühlkörpers (5) in die Kühlkörperaufnahme (20) und vor dem Aufsetzen der Hilfsstruktur (9) auf die Bestückungsseite (2) in der Hilfsstruktur (9) unverlierbar gehalten ist.

4. Elektronische Baugruppe nach Anspruch 1, 2 oder 3,
**dadurch gekennzeichnet,**
**dass** die Kühlkörperaufnahme (20) derart ausgebildet ist, dass der Kühlkörper (5) von derjenigen Seite der Hilfsstruktur (9) aus, die im auf die Bestückungsseite (2) aufgesetzten Zustand der Hilfsstruktur (9) der Leiterplatte (1) zugewandt ist, in die Kühlkörperaufnahme (20) einführbar ist.

5. Elektronische Baugruppe nach einem der obigen Ansprüche,
**dadurch gekennzeichnet,**
**dass** die Hilfsstruktur (9) Abstandhalter (25) aufweist, die von der Bestückungsseite (2) der Leiterplatte (1) weg ragen und in dieser Richtung den Kühlkörper (5) überragen.

6. Elektronische Baugruppe nach einem der obigen Ansprüche,
**dadurch gekennzeichnet,**
**dass** die Hilfsstruktur (9) Anschläge (24) aufweist, mittels derer eine Bewegung des Kühlkörpers (5) in Richtung von der Leiterplatte (1) weg begrenzt wird.

7. Elektronische Baugruppe nach Anspruch 6,
**dadurch gekennzeichnet,**
**dass** die Positionierung der Rückhaltehaken (21) und der Anschläge (24) derart auf den Kühlkörper (5) abgestimmt ist, dass der Kühlkörper (5) in der Kühlkörperaufnahme (20) um maximal 5 mm bewegbar ist.

8. Elektronische Baugruppe nach einem der obigen Ansprüche,
**dadurch gekennzeichnet,**
**dass** der in der Kühlkörperaufnahme (20) angeordnete Kühlkörper (5) bei in die Klammeraufnahme (10) eingesetzter Klammer (7) vor dem Aufsetzen der Hilfsstruktur (9) auf die Bestückungsseite (2) von der Klammer (7) an die Rückhaltehaken (21) angedrückt wird.

9. Elektronische Baugruppe nach einem der obigen Ansprüche,
**dadurch gekennzeichnet,**
**dass** die Hilfsstruktur (9) Positionierstifte (26) aufweist, die in Ausnehmungen der Leiterplatte eingeführt sind.

10. Elektronische Baugruppe nach einem der obigen Ansprüche,
**dadurch gekennzeichnet,**
**dass** die Hilfsstruktur (9) mit der Leiterplatte (1) über die Außenseite der Leiterplatte (1) übergreifende Rasthaken (22) verrastet ist.

## Claims

1. Electronic subassembly,
- wherein the subassembly has a printed circuit board (1) with a component side (2),
- wherein an electronic unit (3) is arranged on the component side (2), which unit on its side remote from the printed circuit board (1) has a cooling surface (4) running parallel to the printed circuit board (1),
- wherein the subassembly has a heat sink (5) which is placed with a contact surface (6) on the cooling surface (4) of the electronic unit (3),
- wherein the subassembly has a clip (7) which overlaps the heat sink (5) at its side remote from the unit (3) and is connected to the printed circuit board (1),
- wherein the subassembly has an auxiliary structure (9) which is placed on the component side (2),
- wherein the auxiliary structure (9) has a clip receiver (10) for the clip (7), into which the clip (7) can be introduced before placement of the auxiliary structure (9) on the component side (2),
- wherein the auxiliary structure (9) has a heat sink receiver (20) into which the heat sink (5) can be introduced before placement of the auxiliary structure (9) on the component side (2) and in which the heat sink (5) is held and guided,
- **characterised in that** the auxiliary structure (9) is made of an electrically insulating material, the heat sink receiver (20) has retaining hooks (21), by means of which a movement of the heat sink (5) in the direction of the printed circuit board (1) is limited, and
- after connection of the clip (7) to the printed circuit board (1) either the heat sink (5) is spaced apart from the retaining hooks (21) or the heat sink (5) is pressed onto the retaining hooks (21) by means of the clip (7) and the auxiliary structure (9) is bent by this pressing-on.

2. Electronic subassembly according to claim 1,
**characterised in that**
the clip receiver (10) is embodied in such a way that the clip (7) can be introduced into the clip receiver (10) from that side of the auxiliary structure (9) which faces the printed circuit board (1) when the auxiliary structure (9) is placed on the component side (2).

3. Electronic subassembly according to claim 1 or 2,
**characterised in that**
the clip (7), when it is situated in the clip receiver (10), is captively held in the auxiliary structure (9) even before the heat sink (5) is introduced into the heat sink receiver (20) and before the auxiliary structure (9) is placed on the component side (2).

4. Electronic subassembly according to claim 1, 2 or 3,
**characterised in that**
the heat sink receiver (20) is embodied in such a way that the heat sink (5) can be introduced into the heat sink receiver (20) from that side of the auxiliary structure (9) which faces the printed circuit board (1) when the auxiliary structure (9) is placed on the component side (2).

5. Electronic subassembly according to one of the above claims,
**characterised in that**
the auxiliary structure (9) has spacers (25) which project away from the component side (2) of the printed circuit board (1) and project over the heat sink (5) in this direction.

6. Electronic subassembly according to one of the above claims,
**characterised in that**
the auxiliary structure (9) has stops (24), by means of which a movement of the heat sink (5) is limited in the direction away from the printed circuit board (1).

7. Electronic subassembly according to claim 6,
**characterised in that**
the positioning of the retaining hooks (21) and the stops (24) is matched to the heat sink (5) in such a way that the heat sink (5) can move by a maximum of 5 mm in the heat sink receiver (20).

8. Electronic subassembly according to one of the above claims,
**characterised in that**
the heat sink (5) arranged in the heat sink receiver (20) is pressed onto the retaining hooks (21) by the clip (7), when the clip (7) is inserted in the clip receiver (10), before placement of the auxiliary structure (9) on the component side (2).

9. Electronic subassembly according to one of the above claims,
**characterised in that**
the auxiliary structure (9) has positioning pins (26) which are introduced into recesses of the printed circuit board.

10. Electronic subassembly according to one of the above claims,
**characterised in that**
the auxiliary structure (9) is latched to the printed circuit board (1) via latching hooks (22) overlapping the outer side of the printed circuit board (1).

## Revendications

1. Module électronique,
- dans lequel le module a une plaquette (1) à circuit imprimé ayant un côté (2) d'insertion,
- dans lequel, du côté (2) d'insertion, est monté un composant (3) électronique, qui a, sur son côté non tourné vers la plaquette (1) à circuit imprimé, une surface (4) de refroidissement s'étendant parallèlement à la plaquette (1) à circuit imprimé,
- dans lequel le module a un dissipateur (5) thermique, qui, par une surface (6) de contact, est posé sur la surface (4) de refroidissement du composant (3) électronique,
- dans lequel le module a une bride (7), qui empiète sur le dissipateur (5) thermique sur son côté non tourné vers le composant (3) et qui est assemblée à la plaquette (1) à circuit imprimé,
- dans lequel le module a une structure (9) auxiliaire, qui est posée sur le côté (2) d'insertion,
- dans lequel la structure (9) auxiliaire a un logement (10) pour la bride (7), dans lequel la bride (7) peut être introduite avant de poser la structure (9) auxiliaire sur le côté (2) d'insertion,
- dans lequel la structure (9) auxiliaire a un logement (20) pour le dissipateur thermique, dans lequel le dissipateur (5) thermique peut être introduit avant de poser la structure (9) auxiliaire sur le côté (2) d'insertion et dans lequel le dissipateur (5) thermique est maintenu et guidé,
- **caractérisé en ce que** la structure (9) auxiliaire est en un matériau isolant électriquement,
**en ce que** le logement (20) pour le dissipateur thermique a des crochets (21) de retenue, au moyen desquels un mouvement du dissipateur (5) thermique en direction de la plaquette (1) à circuit imprimé est limité, et
- **en ce que**, après l'assemblage de la bride (7) à la plaquette (1) à circuit imprimé, ou bien le dissipateur (5) thermique est à distance des crochets (21) de retenue, ou bien le dissipateur (5) thermique est poussé sur les crochets (21) de retenue au moyen de la bride (7) et la structure (9) auxiliaire est courbée par cette poussée.

2. Module électronique suivant la revendication 1,
**caractérisé**
**en ce que** le logement (10) pour la bride est constitué de manière à ce que la bride (7) puisse être introduite dans le logement (10) pour la bride par le côté de la structure (9) auxiliaire, qui, lorsque la structure (9) auxiliaire est à l'état posé sur le côté (2) d'introduction, est tourné vers la plaquette (1) à circuit imprimé.

3. Module électronique suivant la revendication 1 ou 2,
**caractérisé**
**en ce que** la bride (7), lorsqu'elle se trouve dans le logement (10) pour la bride, est maintenue de manière imperdable dans la structure (9) auxiliaire, même avant l'introduction du dissipateur (5) thermique dans le logement (20) pour le dissipateur thermique et avant la pose de la structure (9) auxiliaire sur le côté (2) d'introduction.

4. Module électronique suivant la revendication 1, 2 ou 3,
**caractérisé**
**en ce que** le logement (20) pour le dissipateur thermique est constitué de manière à ce que le dissipateur (5) thermique puisse être introduit dans le logement (20) pour le dissipateur thermique par le côté de la structure (9) auxiliaire, qui, lorsque la structure (9) auxiliaire est dans l'état posé sur le côté (2) d'introduction, est tourné vers la plaquette (1) à circuit imprimé.

5. Module électronique suivant l'une des revendications précédentes,
**caractérisé**
**en ce que** la structure (9) auxiliaire a des entretoises (25), qui font saillie du côté (2) d'introduction de la plaquette (1) à circuit imprimé et dépassent, dans cette direction, le dissipateur (5) thermique.

6. Module électronique suivant l'une des revendications précédentes,
**caractérisé**
**en ce que** la structure (9) auxiliaire a des butées (24) au moyen desquelles un mouvement du dissipateur (5) thermique, dans la direction de la plaquette (1) à circuit imprimé, est limité.

7. Module électronique suivant la revendication 6,
**caractérisé**
**en ce que** le positionnement des crochets (21) de retenue et des butées (24) est adapté au dissipateur (5) thermique, de manière à ce que le dissipateur (5) thermique puisse être déplacé de 5 mm au maximum dans le logement (20) pour le dissipateur thermique.

8. Module électronique suivant l'une des revendications précédentes,
**caractérisé**
**en ce que** le dissipateur (5) thermique disposé dans le logement (20) pour le dissipateur thermique est, lorsque la bride (7) est insérée dans le logement (10) pour la bride avant que la structure (9) auxiliaire soit posée sur le côté (2) d'insertion, poussé par la bride (7) sur les crochets (21) de retenue.

9. Module électronique suivant l'une des revendications précédentes,
**caractérisé**
**en ce que** la structure (9) auxiliaire a des broches (26) de mise en position, qui sont insérées dans des évidements de la plaquette à circuit imprimé.

10. Module électronique suivant l'une des revendications précédentes,
**caractérisé**
**en ce que** la structure (9) auxiliaire est encliquetée avec la plaquette (1) à circuit imprimé par des crochets (22) d'encliquetage empiétant sur le côté extérieur de la plaquette (1) à circuit imprimé.
